(19) **Europäisches Patentamt**

**European Patent Office**

**Office européen des brevets**

(11) **EP 0 902 949 B1**

(12) **FASCICULE DE BREVET EUROPEEN**

| | |
|---|---|
| (45) Date de publication et mention de la délivrance du brevet: **08.03.2000 Bulletin 2000/10** | (51) Int Cl.⁷: **G11C 16/06**, G11C 5/14 |
| (21) Numéro de dépôt: **97926041.1** | (86) Numéro de dépôt international: **PCT/FR97/00922** |
| (22) Date de dépôt: **27.05.1997** | (87) Numéro de publication internationale: **WO 97/48100 (18.12.1997 Gazette 1997/54)** |

(54) **MEMOIRE REMANENTE EFFACABLE ET PROGRAMMABLE ELECTRIQUEMENT, PROTEGEE CONTRE LES COUPURES D'ALIMENTATION**

ELEKTRISCH LÖSCH-UND PROGRAMMIERBARER NICHTFLÜCHTIGER SPEICHER, GESCHÜTZT GEGEN STROMUNTERBRECHUNGEN

ELECTRICALLY ERASABLE AND PROGRAMMABLE NON-VOLATILE MEMORY PROTECTED AGAINST POWER FAILURE

| | |
|---|---|
| (84) Etats contractants désignés: **AT BE CH DE ES FR GB IT LI NL** | • **MARTIN, Michel F-13840 Rognes (FR)** |
| (30) Priorité: **07.06.1996 FR 9607462** | (74) Mandataire: **Marchand, André et al OMNIPAT, 24 Place des Martyrs de la Résistance 13100 Aix-en-Provence (FR)** |
| (43) Date de publication de la demande: **24.03.1999 Bulletin 1999/12** | |
| (73) Titulaire: **Inside technologies 69930 Saint-Clément-les-Places (FR)** | (56) Documents cités: **EP-A- 0 265 312**     **EP-A- 0 376 290** **EP-A- 0 598 475**     **US-A- 5 371 709** |
| (72) Inventeurs: • **KOWALSKI, Jacek F-13530 Trets (FR)** | • **PATENT ABSTRACTS OF JAPAN vol. 95, no. 009 & JP 07 248977 A (FUJI ELECTRIC CO LTD), 26 Septembre 1995,** |

**Description**

La présente invention concerne les mémoires EEPROM (Electricaly Erasable and Programmable Read Only Memory), c'est-à-dire les mémoires rémanentes effaçables et programmables électriquement.

Les mémoires EEPROM ont connu ces dernières années un important développement en raison de leurs caractéristiques avantageuses. En effet, ces mémoires peuvent être programmées et effacées à volonté par application d'une haute tension, désignée communément Vpp. Une fois programmées, ou effacées, elles conservent l'information indéfiniment sans alimentation électrique. En raison de ces propriétés, les mémoires EEPROM représentent le moyen préféré pour l'enregistrement d'informations ou de données de transaction dans les microcircuits montés sur des supports portables ne possédant pas de source d'alimentation autonome, comme les cartes à puce et des étiquettes électroniques, alimentées électriquement uniquement pendant des périodes d'utilisation.

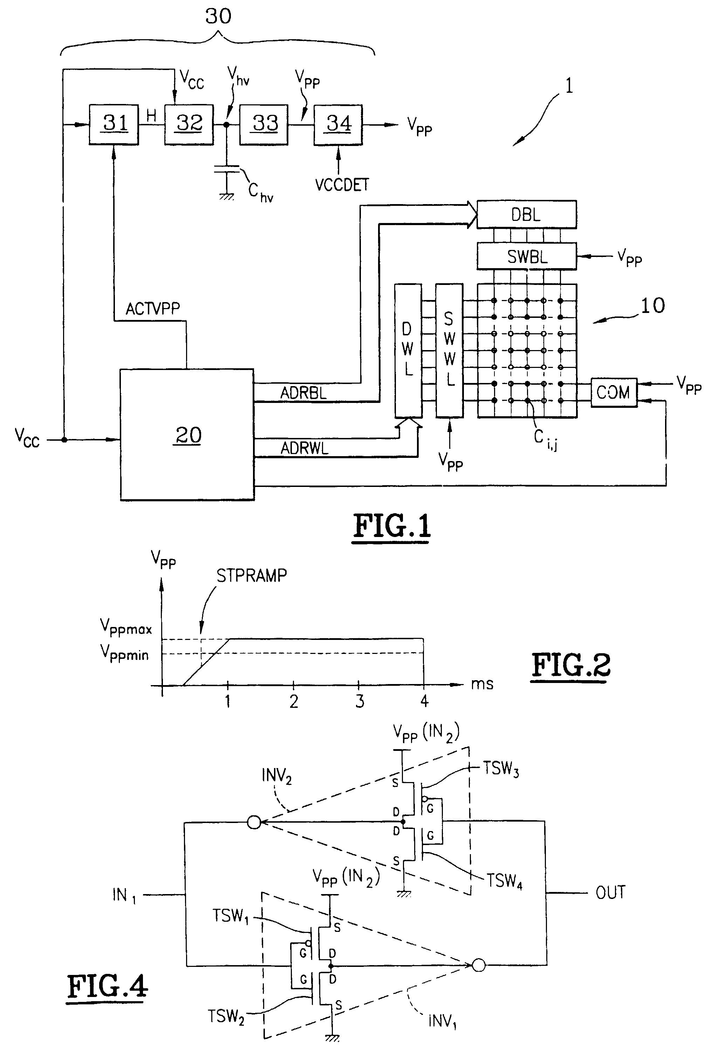

La figure 1 représente schématiquement la structure d'un microcircuit 1 du type précité, équipé d'une mémoire EEPROM 10 comprenant une pluralité de cellules mémoire $C_{i,j}$ disposées en lignes et en colonnes. Le microcircuit comprend en outre un circuit logique 20 (à logique câblée ou à microprocesseur) et une chaîne 30 d'éléments permettant de produire, à partir d'une tension d'alimentation Vcc du microcircuit 1 de l'ordre de 3 à 5V, la haute tension Vpp nécessaire aux opérations d'effacement ou de programmation de la mémoire 10. La chaîne 30 de production de la haute tension Vpp comprend, en série, un circuit survolteur, par exemple une pompe de charges 32 entraînée par un signal d'horloge H délivré par un oscillateur 31, une capacité de stabilisation Chv, un régulateur de tension 33 et un circuit de mise en forme 34 de la tension Vpp.

Lorsqu'une opération d'effacement ou de programmation doit être effectuée, le circuit logique 20 applique à l'oscillateur 31 un signal d'activation ACTVPP et la pompe de charges 32 délivre, à partir de la tension Vcc, une hauts tension Vhv de l'ordre de 22 à 25 volts. La tension Vhv est appliquée à la capacité de stabilisation Chv et sur l'entrée du régulateur 33 dont la sortie délivre la tension Vpp, de l'ordre de 15 à 20 volts. A l'extrémité de la chaîne 30, le circuit de mise en forme 34 applique progressivement la tension Vpp aux cellules mémoire $C_{i,j}$ sous la forme d'une rampe que l'on aperçoit en figure 2.

Dans la mémoire 10, les cellules $C_{i,j}$ sont sélectionnées au moyen d'un décodeur de lignes DWL et d'un décodeur de colonnes DBL recevanc respectivement des adresses ADRWL et ADRBL envoyées par le circuit logique 20. Pour la programmation (mise à "0") ou l'effacement (mise à "1") des cellules $C_{i,j}$, la haute tension Vpp est acheminée vers les cellules $C_{i,j}$ au moyen d'un premier groupe d'interrupteurs SWWL piloté par le décodeur de lignes DWL et d'un deuxième groupe d'interrupteurs SWBL piloté par le décodeur de colonnes DBL. La tension Vpp est également acheminée vers d'autres noeuds internes de la mémoire 10 par un circuit de sélection d'opérations COM contrôlé par le circuit logique 20, permettant de choisir entre une opération de programmation ou d'effacement.

Pour qu'une opération de programmation ou d'effacement se déroule correctement, il est nécessaire que la haute tension Vpp soit maintenue un certain temps, de l'ordre de 4 à 5 ms, nécessaire au transfert de charges électriques dans les cellules mémoire $C_{i,j}$. Or, le problème que pose l'utilisation des mémoires EEPROM dans les microcircuits de cartes à puce ou d'étiquettes électroniques est que la tension d'alimentation Vcc, à partir de laquelle la haute tension Vpp est générée, est susceptible d'être interrompue à tout instant en raison d'une erreur de manipulation de l'utilisateur (par exemple le fait de retirer soudainement une carte à puce du lecteur dans lequel elle est insérée) ou d'une mauvaise transmission de l'énergie, notamment quand la tension Vcc est transmise par induction électromagnétique (cartes à puce sans contact). Si par coïncidence ou tentative de fraude une coupure de la tension d'alimentation Vcc intervient pendant les quelques millisecondes d'une opération d'écriture, des données en cours d'enregistrement risquent de n'être pas enregistrées ou d'être enregistrées avec des anomalies. Ce problème est particulièrement gênant quand les données en cours d'enregistrement représentent une valeur monétaire.

Dans l'état de la technique, ce problème est toléré comme un inconvénient inhérent à l'utilisation des mémoires EEPROM dans les microcircuits ne possédant pas d'alimentation autonome, la démarche adoptée en cas de coupure de la tension d'alimentation consistant simplement à remettre à zéro (Reset) le circuit logique 20 du microcircuit 1 sans se préoccuper de la mémoire. Le brevet français 2 703 501 propose toutefois d'adjoindre à chaque ligne d'une mémoire EEPROM une cellule auxiliaire permettant d'éviter l'écriture de données aberrantes lors d'une coupure de la tension d'alimentation. Toutefois, cette solution concerne spécifiquement le décomptage d'unités selon la méthode dite "du boulier" et ne résout pas le problème général précédemment exposé.

Ainsi, l'objectif de la présente invention est de protéger les mémoires EEPROM contre le risque d'inscription de données erronées en cas de coupure intempestive de la tension d'alimentation.

Pour atteindre cet objectif, la présente invention se base tout d'abord sur la constatation que, dans une mémoire EEPROM, les opérations de programmation ou d'effacement des cellules mémoire s'effectuent avec une consommation de courant insignifiante. Par exemple, dans une mémoire EEPROM réalisée à partir de transistors MOS à grille flottante, la tension Vpp est appliquée entre la grille G et le drain D des transistors MOS, ces deux électrodes étant isolées l'une de l'autre.

Ainsi, une première idée de la présente invention est de maintenir la tension Vpp pendant la durée nécessaire à une opération de programmation ou d'effacement. Un tel maintien est techniquement réalisable, par exemple au moyen d'éléments capacitifs, en raison de la constatation ci-dessus. Une autre idée de la présente invention est de maintenir l'acheminement de la haute tension jusqu'aux cellules de la mémoire lorsque la tension d'alimentation disparaît. En effet, la demanderesse a constaté que, dans les mémoires EEPROM classiques, la disparition de la tension d'alimentation Vcc entraîne la rupture des chemins électriques conduisant la tension Vpp aux cellules en cours de programmation ou d'effacement.

Plus particulièrement, la présente invention prévoit une mémoire programmable et effaçable électriquement, avec les caractéristiques de la revendication 1.

Avantageusement, la capacité apte à maintenir la haute tension comprend une capacité de stabilisation présente dans les moyens de production de la haute tension.

Avantageusement, quand la haute tension est appliquée par l'intermédiaire d'un circuit générateur de rampe, la mémoire comprend des moyens pour inhiber le circuit générateur de rampe en cas de coupure de la tension d'alimentation.

La présente invention concerne également un procédé pour pallier les risques d'inscription de données erronées dans une mémoire programmable et effaçable électriquement lorsqu'une coupure d'une tension d'alimentation de la mémoire intervient au cours d'une opération de programmation ou d'effacement de cellules de la mémoire, avec les caractéristiques de la revendication 12.

Ces caractéristiques, avantages ainsi que d'autres de la présente invention seront exposés plus en détails dans la description suivante du procédé de l'invention et d'un exemple de réalisation d'une mémoire EEPROM selon l'invention, en relation avec les figures jointes parmi lesquelles :

- la figure 1 précédemment décrite représente sous forme de blocs l'architecture générale d'un microcircuit équipé d'une mémoire EEPROM,
- la figure 2 représente la courbe d'une haute tension de programmation ou d'effacement d'une mémoire EEPROM, ayant l'aspect d'une rampe,
- la figure 3 est le schéma électrique d'une mémoire EEPROM selon la présente invention,
- la figure 4 représente de façon plus détaillée un élément interrupteur de la mémoire de la figure 3,
- la figure 5 est le schéma électrique selon l'invention d'un circuit générateur de la rampe de tension de la figure 2,
- la figure 6 est le schéma électrique d'un circuit de détection selon l'invention d'une coupure de la tension d'alimentation,
- la figure 7 est le schéma électrique d'un circuit de détection selon la présente invention d'une haute tension de programmation ou d'effacement,
- la figure 8 est le schéma logique d'un circuit délivrant un signal d'inhibition du circuit générateur de rampe de la figure 5,
- la figure 9 représente une variante de réalisation du circuit de détection de la figure 6, et
- la figure 10 est un organigramme représentant le fonctionnement d'un microcircuit comprenant une mémoire selon l'invention.

Afin de pallier les risques d'enregistrement de données erronées dans une mémoire EEPROM 10 du type déjà décrit en relation avec la figure 1, la présente invention propose de prévoir des dispositions techniques permettant de garantir qu'une opération de programmation ou d'effacement commencée va se terminer même si la tension d'alimentation Vcc disparaît. Plus particulièrement, la présente invention propose les dispositions suivantes :

- (A) maintenir l'acheminement de la haute tension Vpp vers les cellules $C_{i,j}$ de la mémoire en l'absence de la tension d'alimentation Vcc,
- (B) maintenir la haute tension Vpp au moins pendant la durée nécessaire à l'opération de programmation ou d'effacement. A cet effet, on pourrait recourir à une capacité externe à la microplaquette de silicium sur laquelle est intégrée la mémoire, mais cela représenterait un handicap au plan industriel notamment pour la réalisation de cartes à puce ou d'étiquettes électroniques. De préférence, la présente invention propose de maintenir la haute tension au moyen d'éléments capacitifs déjà présents dans la chaîne 30 de production de la haute tension Vpp, en particulier au moyen de la capacité de stabilisation Chv déjà décrite.
- (C) inhiber ou mettre hors tension des éléments de la chaîne 30 de production de la haute tension Vpp susceptibles de consommer du courant. Cette dernière disposition, facultative, permet de diminuer la valeur des éléments capacitifs assurant le maintien de la tension Vpp, et par conséquent leur encombrement.

On décrira tout d'abord un exemple de réalisation d'une mémoire EEPROM satisfaisant la disposition A.

**Disposition A : maintien de l'acheminement de la haute tension Vpp**

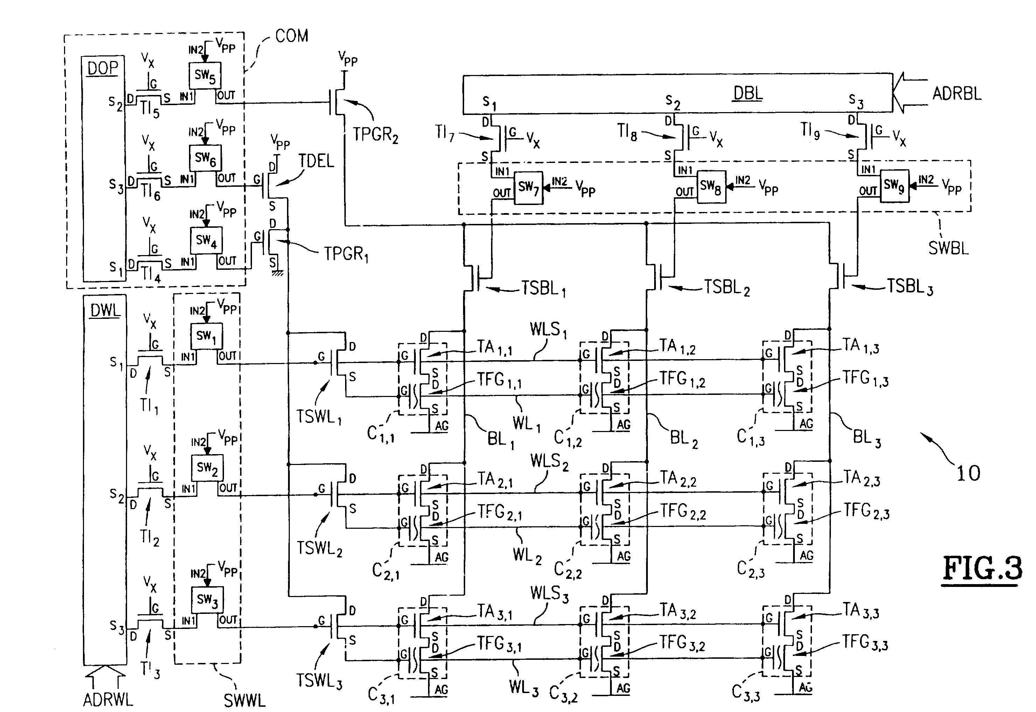

La figure 3 représente de façon détaillée un mode de réalisation selon la présente invention de la mémoire EEPROM 10 dont l'architecture générale a déjà été présentée en relation avec la figure 1. Dans un souci de simplicité, la mémoire 10 représentée ne comporte que neuf cellules mémoire $C_{i,j}$ disposées en lignes et en colonnes, les indices i et j allant de 1 à 3 et représentant respectivement le rang de la ligne et de la colonne à laquelle appartient chaque cellule $C_{i,j}$.

De façon classique, chaque cellule mémoire $C_{i,j}$ comprend un transistor d'accès $TA_{i,j}$ et un transistor à grille flottante $TFG_{i,j}$ connecté par son drain D au transistor d'accès $TA_{i,j}$. Chaque transistor à grille flottante $TFG_{i,j}$ est connecté par sa source S à une ligne conductrice AG. La ligne conductrice AG, commune à tous les autres transistors à grille flottante, est portée à un potentiel flottant pendant les opérations de programmation et au potentiel 0 (masse) pendant les opérations d'effacement. Les grilles G des transistors à grille flottante $TFG_{i,j}$ d'une même ligne (même indice i) sont connectées par une ligne conductrice commune $WL_i$ ($WL_1$, $WL_2$, $WL_3$) à la source S d'un transistor $TSWL_i$ ($TSWL_1$, $TSWL_2$, $TSWL_3$) de sélection de ligne. Les grilles G des transistors d'accès $TA_{i,j}$ des cellules d'une même ligne sont reliées par l'intermédiaire d'une ligne conductrice commune $WLS_i$ ($WLS_1$, $WLS_2$, $WLS_3$) à la grille du transistor $TSWL_i$ de sélection de la ligne. Les drains D des transistors $TSWL_i$ de sélection de lignes sont tous connectés au drain D d'un transistor de programmation $TPGR_1$ et à la source S d'un transistor d'effacement TDEL. Le transistor de programmation $TPGR_1$ a sa source S connectée à la masse et le transistor d'effacement TDEL reçoit la haute tension Vpp sur son drain D quand la chaîne 30 de la figure 1 est activée. Par ailleurs, les drains D des transistors d'accès $TA_{i,j}$ d'une même colonne sont reliés par une ligne conductrice commune $BL_i$ ($BL_1$, $BL_2$, $BL_3$) à la source S d'un transistor $TSBL_i$ ($TSBL_1$, $TSBL_2$, $TSBL_3$) de sélection de colonne. Enfin, les drains D des transistors de sélection de colonne $TSBL_i$ ($TSBL_1$, $TSBL_2$, $TSBL_3$) sont tous connectés à la source S d'un transistor de programmation $TPGR_2$ dont le drain D reçoit la haute tension Vpp.

Selon l'invention, les grilles G des transistors permettant l'acheminement dans la mémoire 10 de la tension Vpp, la sélection des cellules $C_{i,j}$ et la connexion à la masse, ici les transistors de sélection de lignes $TSWL_1$, $TSWL_2$, $TSWL_3$, de programmation $TPGR_1$, $TPGR_2$, d'effacement TDEL et de sélection de colonnes $TSBL_1$, $TSBL_2$, $TSBL_3$, sont pilotées par des interrupteurs à mémoire, respectivement $SW_1$, $SW_2$, $SW_3$, $SW_4$, $SW_S$, $SW_6$, $SW_7$, $SW_8$, $SW_9$, qui maintiennent la tension Vpp ou la tension 0 (masse) sur leurs sorties OUT même si la tension d'alimentation Vcc disparaît. Chaque interrupteur $SW_i$ comporte une sortie OUT connectée à la grille de l'un des transistors susmentionnés, une entrée de commande IN1 et une entrée d'alimentation IN2 recevant la haute tension Vpp. Les entrées de commande IN1 des interrupteurs $SW_1$, $SW_2$, $SW_3$ sont pilotées par des sorties S1, S2, S3 du décodeur de lignes DWL, par l'intermédiaire de transistors d'isolement $TI_1$, $TI_2$, $TI_3$. Les entrées de commande IN1 des interrupteurs $SW_4$, $SW_5$, $SW_6$ sont pilotées par des sorties S1, S2, S3 d'un décodeur d'opérations DOP, par l'intermédiaire de transistors d'isolement $TI_4$, $TI_5$, $TI_6$. Enfin, les entrées de commande IN1 des interrupteurs $SW_7$, $SW_8$, $SW_9$ sont pilotées par des sorties S1, S2, S3 du décodeur de colonnes DBL, par l'intermédiaire de transistors d'isolement $TI_7$, $TI_8$, $TI_9$ (pour établir la correspondance avec l'architecture générale représentée en figure 1, on a délimité par des traits pointillés sur la figure 3 les groupes d'interrupteurs SWWL et SWBL et le circuit de sélection d'opérations COM). Ici, les transistors d'isolement $TI_1$ à $TI_9$ sont des transistors MOS dont la grille G est commandée par un signal Vx qui sera décrit plus loin.

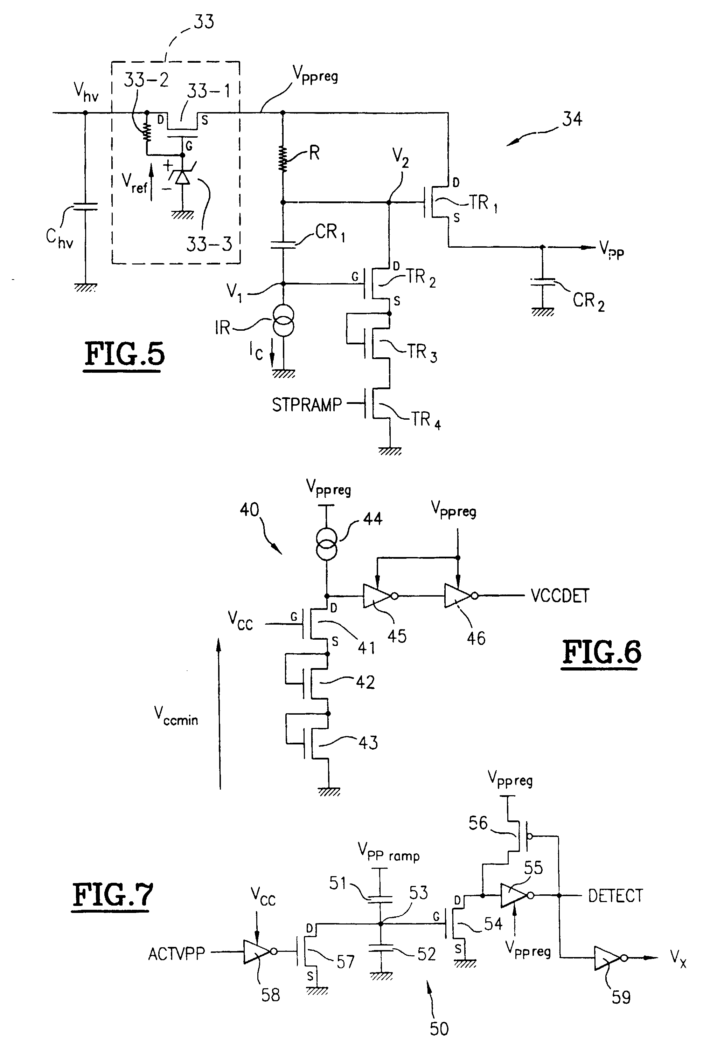

La figure 4 représente un exemple de réalisation d'un interrupteur à mémoire $SW_i$ selon l'invention. L'interrupteur comprend deux portes inverseuses $INV_1$, $INV_2$ montées tête-bêche et alimentées par la haute tension Vpp. La sortie de la porte $INV_1$ forme la sortie OUT de l'interrupteur $SW_i$ et est ramenée sur l'entrée de la porte INV2. La sortie de la porte $INV_2$ forme l'entrée de commande IN1 de l'interrupteur et est ramenée sur l'entrée de la porte INV1. Ici, les portes inverseuses INV1, INV2 sont de type CMOS et comprennent chacune un transistor PMOS $TSW_1$, respectivement $TSW_3$, et un transistor NMOS $TSW_2$, respectivement $TSW_4$, la haute tension Vpp étant appliquée sur les sources S des transistors PMOS. On voit que la structure en boucle fermée des interrupteurs $SW_i$ permet de maintenir indéfiniment l'état de leur sortie OUT, tant que la tension Vpp est présente. Par ailleurs, l'état de la sortie OUT peut être modifié par une commande inverse sur l'entrée IN1, les interrupteurs étant ici inverseurs pour des raisons de simplicité de réalisation. Notons toutefois que les interrupteurs $SW_i$ pourraient être réalisés non inverseurs, par exemple au moyen de quatre portes inverseuses en boucle fermée ou par toute autre agencement électronique à la portée de l'homme de l'art.

Pour réaliser une opération de programmation ou d'effacement de cellules $C_{i,j}$ de la mémoire 10, la sortie OUT de certains interrupteurs $SW_i$ doit être mise à 1 (c'est-à-dire à la tension Vpp) et y rester même en cas de coupure de la tension d'alimentation Vcc. Considérons à titre d'exemple en se référant à nouveau à la figure 3 que l'on veuille programmer (c'est-à-dire mettre dans l'état logique "1") la cellule $C_{1,1}$. Les transistors $TSWL_1$, $TA_{1,1}$ et $TSBL_1$ doivent être rendus passants pour que la cellule $C_{1,1}$ soit sélectionnée. Le transistor $TPGR_2$ doit être rendu passant pour que la tension Vpp soit acheminée jusqu'au drain D du transistor à grille flottante $TFG_{1,1}$ et le transistor $TPGR_1$ doit être rendu passant pour que la grille G du transistor $TFG_{1,1}$ soit portée à la masse et que le transfert de charge par effet tunnel se réalise dans le transistor $TFG_{1,1}$. Ainsi, les opérations suivantes doivent être réalisées :

(i) démarrage de la chaîne de production de la haute tension Vpp représentée en figure 1,

(ii) mise à 0 de la sortie S1 du décodeur de lignes DWL, des sorties S1 et S2 du décodeur d'opérations DOP et de la sortie S1 du décodeur de colonnes DBL, toutes les autres sorties des décodeurs étant à 1, c'est-à-dire à la tension Vcc, les décodeurs étant de façon classique alimentés par la tension Vcc.

(iii) le signal Vx est mis à 1 et les transistors d'isolement $TI_i$ sont rendus passants afin que les sorties des décodeurs DWL, DOP, DBL attaquent les entrées IN1 des interrupteurs à mémoire SW1 à SW9. Au terme de cette étape, la tension Vpp (le "1" logique des interrupteurs $SW_i$) se retrouve sur les sorties OUT des interrupteurs SW1, SW4, SW5 et SW7 et sur les entrées IN1 des interrupteurs $SW_2$, $SW_3$, $SW_6$, $SW_8$, $SW_9$ dont les sorties OUT sont à la masse ("0" logique). La tension Vpp étant présente sur les entrées IN1 des interrupteurs $SW_2$, $SW_3$, $SW_6$, $SW_8$, $SW_9$, la source S des transistors d'isolement correspondant $TI_2$, $TI_3$, $TI_6$, $TI_8$, $TI_9$ est à un potentiel plus élevé que leurs drains D, qui sont à la tension Vcc, et ces transistors sont bloqués, isolant ainsi la tension Vpp de la tension Vcc.

Une fois ces opérations réalisées, les transistors $TSWL_1$, $TA_{1,1}$, $TPGR_1$, $TPGR_2$ et $TSBL_1$ reçoivent la tension Vpp sur leurs grilles G et sont passants. La tension Vpp est acheminée au drain D du transistor à grille flottante $TFG_{1,1}$ par l'intermédiaire des transistors $TSBL_1$ et $TPGR_2$. La grille G de $TFG_{1,1}$ est connectée à la masse par l'intermédiaire des transistors $TPGR_1$ et $TSWL_1$. Le processus classique de transfert de charge par effet tunnel dans la grille flottante du transistor $TFG_{1,1}$ commence et doit être poursuivi pendant quelques millisecondes.

Avantageusement, si la tension Vcc disparaît au cours du processus de programmation et que les sorties des décodeurs DWL, DOP, DBL se retrouvent à 0 faute d'alimentation électrique, les interrupteurs $SW_i$ conservent leur état de sortie OUT tant que la tension Vpp est présente et l'acheminement de la tension Vpp est maintenu. De plus, le transistor $TPGR_1$ qui assure l'acheminement de la tension 0 (masse) est commandé par l'interrupteur $SW_4$ et reste passant tant que la tension Vpp existe. Dans l'art antérieur, un tel transistor était commandé directement par la tension Vcc, de sorte qu'une disparition de la tension Vcc entraînait la coupure du chemin menant à la masse. Enfin, les avantages de l'invention se retrouvent pour les opérations d'effacement (passage dans l'état logique "0" d'une ligne de cellules $C_{i,j}$) qui nécessitent de rendre passant le transistor TDEL ainsi que le transistor $TSWL_i$ de la ligne à effacer.

Le premier objectif de l'invention étant atteint, le nécessaire doit être fait pour garantir le maintien de la tension Vpp pendant la durée d'une opération de programmation ou d'effacement. Comme un objectif secondaire de la présente invention est de ne pas augmenter de manière rédhibitoire la surface occupée par la capacité utilisée à cet effet, ni recourir à une capacité externe, on va tout d'abord faire le nécessaire pour que le courant consommé en cas de disparition de la tension Vcc soit le plus faible possible (disposition C).

**Disposition C : mise hors tension ou inhibition de certains éléments**

Dans le cas de la chaîne 30 représentée en figure 1, les seuls éléments susceptibles de décharger la capacité de maintien de la tension Vpp sont le régulateur 33 et le générateur de rampe 34, dont le fonctionnement entraîne généralement la consommation d'un petit courant. En effet, l'oscillateur 31 et la pompe de charges 32 (ou tout autre circuit survolteur) cessent de fonctionner lorsque la tension Vcc disparaît.

La figure 5 représente un exemple de réalisation particulièrement simple d'un ensemble régulateur 33 et générateur de rampe 34 ne consommant pas de courant quand une coupure de la tension d'alimentation Vcc intervient, le générateur de rampe 34 pouvant être inhibé par un signal STPRAMP.

Le régulateur 33 comprend, de façon classique, un transistor MOS 33-1 dont la grille G est ramenée sur le drain par l'intermédiaire d'une résistance 33-2. La grille G du transistor 33-1 est polarisée par une diode zener 33-3 délivrant une tension de référence Vref. On désignera par Vppreg la tension à la sortie du régulateur 33.

A l'entrée du circuit générateur de rampe 34, la tension Vppreg est appliquée sur le drain D d'un transistor $TR_1$ et à l'extrémité d'une résistance R. L'autre extrémité de la résistance R est connectée à la grille G du transistor $TR_1$ et à l'anode d'une capacité $CR_1$. La cathode de la capacité $CR_1$ est connectée à la grille G d'un transistor $TR_2$ et à une source de courant IR imposant à la capacité $CR_1$ un courant de charge Ic de faible valeur. Le transistor $TR_2$ a son drain D connecté à la grille G du transistor $TR_1$. Sa source S est connectée à la masse par l'intermédiaire d'un transistor $TR_3$ fonctionnant comme une diode (grille ramenée sur le drain) en série avec un transistor $TR_4$. La grille G du transistor $TR_4$ est commandée par un signal STPRAMP mis à 0 quand la tension d'alimentation Vcc disparaît. La sortie du circuit générateur de rampe 34 est prélevée sur la source S du transistor $TR_1$ et est stabilisée par une capacité $CR_2$.

Lorsque le signal STPRAMP est à 1 (transistor $TR_4$ passant) et que la tension Vppreg monte rapidement à l'entrée du circuit 34 (la pompe de charges 32 étant activée par l'oscillateur 21), la tension V1 présente sur la cathode de la capacité $CR_1$ monte rapidement car le courant de charge Ic est choisi suffisamment petit pour que la capacité $CR_1$ ne puisse pas absorber rapidement la variation de tension due à l'apparition de la tension Vppreg. Quand la tension V1 dépasse la valeur 2VT, VT étant la tension de seuil des transistors $TR_2$, $TR_3$, le transistor $TR_2$ commence

à conduire et ralentit la montée de la tension V2 présente sur la grille du transistor $TR_1$. Avec la charge de la capacité $CR_1$, la tension V2 monte lentement jusqu'à atteindre la valeur de Vppreg. La tension Vpp est égale à la tension V2 à laquelle est soustraite la tension de seuil VT du transistor $TR_1$. La courbe de la tension Vpp, représentée sur la figure 2, présente une première partie en forme de rampe, suivie d'un plateau ou Vpp est égale à sa valeur maximale Vppmax :

$$(1) \qquad Vppmax = Vppreg - VT$$

VT désignant ici la tension de seuil du transistor $TR_1$.

On voit que la consommation de courant pendant la génération de la rampe est due principalement aux transistors $TR_2$, $TR_3$, $TR_4$ et au courant traversant la diode zener 33-3 du régulateur 33. Lorsque le signal STPRAMP est mis à 0, le transistor $TR_4$ et par conséquent les transistors $TR_2$ et $TR_3$ ne sont plus conducteurs et ne consomment plus. La capacité $CR_1$ est rendue flottante et la tension V2 de la grille du transistor $TR_1$ monte rapidement à la tension Vppreg. Les charges électriques stockées dans la capacité Chv sont transférées dans la capacité $CR_2$, la diode zener 33-3 se bloque et la tension Vpp atteint sa valeur maximale Vppmax en un instant très bref, comme représenté en traits pointillés sur la figure 2.

**Disposition B : maintien de la tension Vpp**

Dans les lignes qui suivent, on va montrer que les capacités internes de la chaîne 30, ici les capacités Chv, $CR_1$ et $CR_2$, peuvent assurer seules le maintien de la haute tension Vpp, sans augmentation rédhibitoire de la surface de silicium occupée par ces capacités.

Si l'on se réfère à nouveau à la figure 5, on voit que lorsque le signal STPRAMP est mis à 0, la capacité Chv à la sortie de la pompe de charges 32 doit être en mesure d'assurer le transfert de sa charge électrique dans la capacité $CR_2$ pour que la tension Vpp atteigne rapidement une valeur Vprog suffisante pour assurer la poursuite du processus de programmation ou d'effacement commencé. Dans l'exemple particulier de réalisation qui vient d'être donné, à l'instant où STPRAMP passe à 0, la charge totale Q1 stockée par la chaîne 30 est égale à :

$$(2) \qquad Q1 = Vhv\ Chv + K\ Vppreg\ CR_1 + (KVppreg-VT)CR_2$$

(KVppreg-VT) étant la valeur de la tension Vpp au moment de la coupure de la tension d'alimentation Vpp, K étant un paramètre compris entre 0 et 1, VT étant la tension de seuil du transistor $TR_1$.

Après le transfert de charges, la tension Vhv aux bornes de Chv est à peu près égale à Vppreg, le transistor 33-1 du régulateur 33 se comportant comme une simple diode, la diode zener 33-3 n'étant plus conductrice. Si le transfert de charges s'est effectué correctement, la charge totale Q1 peut alors s'écrire :

$$(3) \qquad Q1 = Vprog\ (Chv + CR_1 + CR_2) - VT\ CR_2$$

Vprog désignant la valeur finale de la tension de programmation Vpp après le transfert de charges.

En combinant les relations (2) et (3), on en déduit que :

$$(4) \qquad Chv = (Vprog - K\ Vppreg)\ (CR_1 + CR_2)/[Vhv - Vprog]$$

Une fois tension de programmation Vprog choisie, la détermination de la capacité Chv est une étape pratique à la portée de l'homme de l'art. On doit tenir compte du fait que, malgré les précautions qui viennent d'être prises, des courants de fuites inhérents à la technologie des circuits intégrés vont subsister. Par exemple, si l'on choisit les valeurs suivantes:

$CR_1 = 5$ pF,
$CR_2 = 3$ pF,
Vhv = 22 V
Vppreg = 20 V,
Vprog = 19 V,

et si l'on suppose que le transfert de charges va se faire à 75% de la rampe de tension, K étant égal à 0.75, la relation (4) donne une valeur minimale de Chv égale à 10.6 pF, ce qui représente, avec les capacités $CR_1$ et $CR_2$, une capacité totale équivalente d'environ 18 pF pour l'ensemble de la chaîne 30. En présence d'un courant de fuite de 10 nA, une telle capacité permet de maintenir la tension Vprog pendant 1,8 millisecondes avec une baisse de tension de seulement 1V au terme de cette période, ce qui est suffisant pour garantir une bonne programmation.

## Optimalisation de l'encombrement de la capacité Chv

Il ressort de la relation (4) que la valeur de la capacité Chv nécessaire au transfert des charges est d'autant plus élevée que le terme K est petit. Ainsi, si l'on souhaite que la capacité Chv soit de faible valeur et de faible encombrement tout en permettant le transfert de charges vers la capacité $CR_2$, le terme K doit être proche de 1 et la coupure de tension Vcc doit de préférence intervenir au moment où la tension Vpp est la plus proche de sa valeur maximale Vppmax.

Ici, une idée de la présente invention est de ne pas déclencher le signal STPRAMP quand la tension Vpp présente une valeur inférieure à un seuil d'efficacité Vppmin à partir duquel la tension Vpp commence à agir sur les cellules $C_{i,j}$ de la mémoire. Typiquement, le seuil Vppmin est de l'ordre de 15V pour les mémoires EEPROM utilisant des transistors à grille flottante. Cet aspect optionnel de la présente invention permet d'optimaliser l'encombrement de la capacité Chv et, d'autre part, d'éviter le transfert de la charge de la capacité Chv lorsqu'une opération de programmation ou d'effacement n'a pas réellement commencé malgré l'activation de la chaîne 30 de production de la tension Vpp.

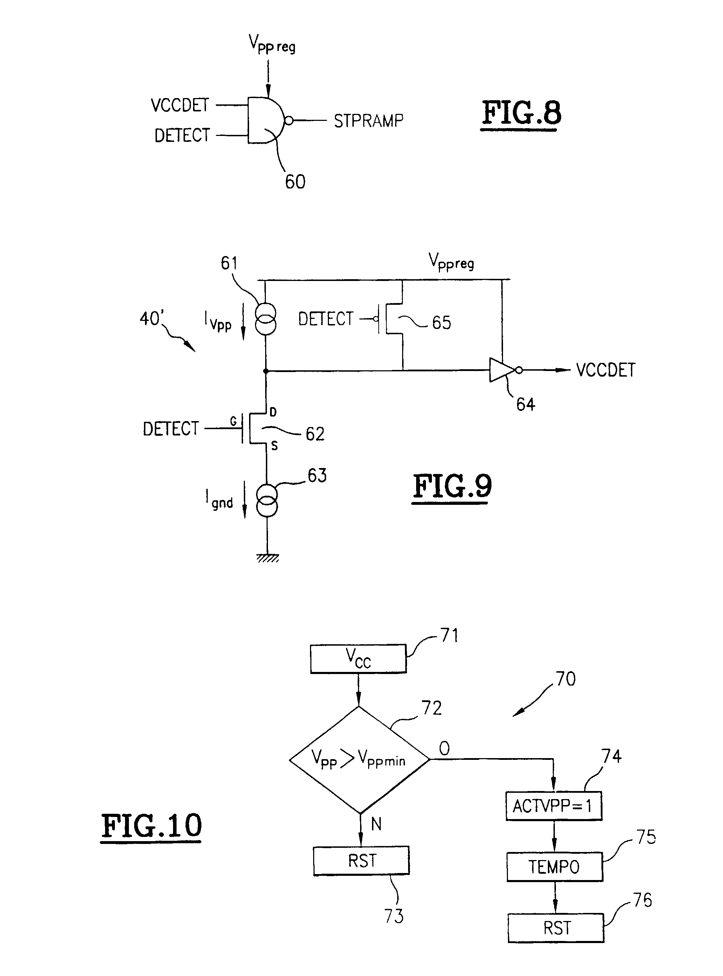

Les figures 6, 7 et 8 représentent des circuits permettant de produire le signal STPRAMP dans les conditions qui viennent d'être mentionnées. Le circuit 40 de la figure 6 est un circuit de détection des coupures de la tension Vcc, produisant un signal de coupure VCCDET. Le circuit 50 de la figure 7 permet de produire un signal DETECT lorsque la tension Vpp atteint le seuil d'efficacité Vppmin. Enfin, la figure 8 représente un circuit logique qui combine VCCDET et DETECT pour produire le signal STPRAMP. De façon générale, on notera que la plupart des portes logiques utilisées pour réaliser les circuits des figures 6, 7, 8 sont alimentées par la tension Vppreg afin de n'être pas affectées par une coupure de la tension Vcc. De préférence, ces portes logiques sont réalisées au moyen de la technologie CMOS de manière à ne pas consommer de courant en dehors des périodes de commutation.

Le circuit 40 de la figure 6 comprend un transistor MOS 41 recevant sur sa grille G la tension d'alimentation Vcc. La source S du transistor 41 est connectée à la masse par l'intermédiaire de deux transistors MOS 42, 43 en série fonctionnant comme des diodes. Le drain D du transistor 41 est relié à la tension Vppreg par l'intermédiaire d'une source de courant 44, ainsi qu'à l'entrée d'une porte inverseuse 45. La sortie de la porte 45 attaque l'entrée d'une deuxième porte inverseuse 46 qui délivre le signal VCCDET. Le signal VCCDET passe à 1 lorsque la tension Vcc devient inférieure à une valeur de seuil Vccmin égale à la somme des tensions de seuil des transistors 41, 42, 43. On choisira par exemple Vccmin égale à 3V.

Le circuit 50 de la figure 7 comprend un pont diviseur de la tension Vpp formé par deux capacités 51, 52. Le point milieu 53 du pont diviseur est connecté à la grille G d'un transistor MOS 54. Les capacités 51 et 52 sont choisies pour que la tension du point milieu soit égale à la tension de seuil VT du transistor 54 quand la tension Vpp atteint sa valeur d'efficacité Vppmin. La source S du transistor 54 est à la masse et son drain D est connecté à l'entrée d'une porte inverseuse 55 dont la sortie délivre le signal DETECT. L'état logique de la porte 55 est stabilisé par un transistor MOS 56 de type P alimenté par la tension Vppreg. Enfin, un transistor MOS 57 commandé par le signal ACTVPP par l'intermédiaire d'une porte inverseuse 58 relie le point milieu 53 du pont diviseur à la masse. Ainsi, quand le signal ACTVPP est à 0, c'est-à-dire en dehors des périodes d'activation de la chaîne 30 de production de la tension Vpp, le circuit 50 est désactivé, la sortie DETECT est à 0. Quand ACTVPP est mis à 1, la tension au point milieu 53 monte jusqu'à atteindre la tension de seuil VT du transistor 54. A cet instant, la tension Vpp est égale à Vppmin, le transistor 54 s'ouvre et le signal DETECT passe à 1.

Comme on le voit en figure 8, les signaux VCCDET et DETECT sont combinés par une porte logique 60 de type NON-ET (NAND) dont la sortie délivre le signal STPRAMP. Pour que le signal STPRAMP passe à 0 et inhibe le circuit 34 générateur de rampe de la figure 5, il faut que VCCDET et DETECT soient tous deux à 1.

Par ailleurs, si l'on se réfère à nouveau à la figure 7, on voit que le signal DETECT peut être utilisé pour produire le signal Vx de commande des transistors d'isolement $TI_i$ de la mémoire 10 (figure 3). Le signal Vx est délivré par une porte inverseuse 59 recevant en entrée le signal DETECT et passe ainsi à 0 quand la tension Vpp atteint le seuil d'efficacité Vppmin. L'avantage est que le signal Vx est automatiquement mis à zéro et les interrupteurs d'isolement $T_i$ définitivement fermés quand le signal DETECT passe à 1. Ainsi, en cas de coupure ultérieure de la tension Vcc, aucun courant inverse susceptible de traverser les interrupteurs $T_i$ quand le signal Vx n'est pas à 0 ne pourra apparaître.

La figure 9 représente une variante 40' du circuit 40 de la figure 6. Le circuit 40' détecte les coupures de la tension Vcc en surveillant la tension Vppreg à la sortie du régulateur 33, au lieu de surveiller la tension Vcc elle-même. L'avantage est que l'on s'affranchit des micro-coupures ou des fluctuations de la tension Vcc qui sont de trop courte durée pour justifier le déclenchement du mécanisme de protection selon l'invention. Une première source de courant 61 délivrant un courant Ivpp est disposée entre la sortie du régulateur 33 et le drain D d'un transistor NMOS 62 recevant sur sa grille G le signal DETECT. La source S du transistor 62 est reliée à la masse par l'intermédiaire d'une deuxième source de courant 63 délivrant un courant Ignd. Le drain D du transistor 62 attaque l'entrée d'une porte inverseuse 64 alimentée par la tension Vppreg et délivrant le signal VCCDET. Enfin, un transistor NMOS 65 commandé par le signal DETECT est disposé entre la tension Vppreg et l'entrée de la porte inverseuse 64. Les sources de courant 61 et 63 sont réglées de manière que le courant Ivpp soit supérieur au courant Ignd quand la tension Vppreg est à sa valeur normale Vregnom. Quand le signal DETECT passe à 1, le transistor 62 est passant, le courant Ivpp surpasse le courant Ignd et la tension au drain D du transistor 62 est proche de Vppreg. Si la tension Vppreg faiblit, notamment suite à une coupure de la tension d'alimentation Vcc, le courant Ivpp diminue, la tension du drain D baisse et provoque la commutation de la porte inverseuse 64 dont la sortie VCCDET passe à 1. D'autre part, quand le signal DETECT est à 0, le circuit 40' est bloqué et le transistor 65 force à 0 le signal VCCDET. Ainsi, le signal VCCDET ne peut passer à 1 tant que le signal DETECT n'est pas à 1. La porte NON-ET de la figure 8 devient donc inutile, le signal inverse / VCCDET du signal VCCDET pouvant être utilisé comme signal STPRAMP.

Dans ce qui précède, on s'est intéressé à la protection d'une mémoire EEPROM intégrée dans un microcircuit 1 comprenant diverses fonctionnalités, représentées symboliquement par le circuit logique 20. Dans le domaine des cartes à puce, ces fonctionnalités sont par exemple la gestion d'opérations de transaction, la réalisation d'opérations de cryptage permettant de lutter contre la fraude, etc., la mémoire EEPROM étant utilisée par le microcircuit 1 comme un moyen d'enregistrement et de stockage de données. Toutefois, il est bien évident que la présente invention peut s'appliquer à un microcircuit 1 ne possédant pas le circuit logique 20, c'est-à-dire un simple microcircuit-mémoire EEPROM, les décodeurs DWL, DOP, et DBL pouvant être commandés depuis l'extérieur.

Quand le microcircuit 1 possède effectivement les fonctionnalités qui viennent d'être évoquées, la mise en oeuvre de l'invention peut, dans certaines applications, soulever une difficulté liée à l'existence de micro-coupures de la tension Vcc, d'une durée inférieure à la durée d'une opération de programmation ou d'effacement. En effet, si le circuit logique 20 est systématiquement mis à 0 (Reset) à la mise sous tension, comme c'est l'usage dans l'art antérieur, il peut arriver que le circuit logique 20 lance une nouvelle opération de programmation ou une opération de lecture de la mémoire alors qu'une opération de programmation, commencée avant la micro-coupure, n'est pas terminée. Dans ce cas, la présente invention prévoit les dispositions complémentaires suivantes :

- (D) prévoir une étape de temporisation au moins égale la durée d'une opération de programmation ou d'effacement lorsque la tension d'alimentation Vcc apparaît. Après cette étape de temporisation, le circuit logique 20 pourra être remis à zéro.
- (E) l'étape de temporisation n'est réalisée que si la haute tension Vpp est présente à la sortie de la chaîne 30. Cette variante de la disposition D peut consister à déterminer si la capacité Chv est dans un état chargé ou déchargé avant d'exécuter l'étape de temporisation. En effet, lorsque le microcircuit 1 se "réveille" à la mise sous tension Vcc, il ne sait pas si l'apparition de Vcc fait suite à un micro-coupure ou une coupure de longue durée. Le test de la présence de Vpp ou Vhv permet de lever cette incertitude de façon avantageuse. Une manière simple de réaliser ce test consiste à lire la sortie du circuit 50 de la figure 7. Si le signal DETECT est à 1, il faut temporiser la remise à zéro du circuit logique 20.
- (F) la chaîne 30 de production de la tension Vpp est activée pendant la temporisation. Cette disposition est un perfectionnement des dispositions D et E. En effet, si la tension Vpp n'est pas nulle à la mise sous tension (par exemple parce que le signal DETECT est à 1), il peut être avantageux de remettre en fonctionnement la pompe de charges 32 au lieu de laisser les capacités Chv et $CR_2$ (figure 5) assurer seules la fin de l'opération de programmation ou d'effacement en cours.

Ce mode de fonctionnement du microcircuit 1 est illustré par l'organigramme 70 de la figure 10. A la mise sous tension Vcc (étape 71), le circuit logique 20 regarde si la tension Vpp est présente (étape 72). Ce test peut consister à regarder si la tension Vpp est supérieure à Vppmin, par exemple au moyen du signal DETECT. Si le test est affirmatif, le circuit 20 active la chaîne 30 (étape 74, ACTVPP = 1)) et attend quelques millisecondes (étape 75, TEMPO). Puis, le circuit 20 génère sa propre remise à zéro (étape 76, RST). Si le test de l'étape 72 est négatif, le circuit 20 se remet à zéro immédiatement après sa mise sous tension (étape 73, RST).

Dans ce qui précède, on a décrit un exemple de mise en oeuvre de la présente invention lié à une structure particulière de mémoire EEPROM utilisant des transistors à grille flottante, et une structure particulière de la chaîne de production de la haute tension Vpp. L'homme de l'art pourra, à partir des indications et exemples donnés dans les présentes, appliquer l'invention à d'autres types de mémoires EEPROM, dans la mesure où ces mémoires ne consomment pas de courant pendant les périodes de programmation ou d'effacement, ce qui, normalement, est toujours le cas.

Par ailleurs, le circuit 34 générateur de rampe peut, selon le type de mémoire EEPROM utilisée, s'avérer inutile. Il doit être rappelé que l'application d'une rampe de tension Vpp aux cellules mémoire a seulement pour but de protéger les cellules d'une lente détérioration que pourrait entraîner l'application brutale de la tension Vpp à chaque opération de programmation ou d'effacement. Cette rampe de tension peut s'avérer nécessaire avec certains types de cellules, notamment celles qui utilisent des transistors à grille flottante. Toutefois, une telle rampe de tension n'est pas impérative à la programmation. De plus, l'homme de l'art notera que le fait de couper cette rampe de tension dans les cas exceptionnels où la présente invention intervient n'a pas d'incidence notable sur la durée de vie des cellules. Enfin, l'utilisation d'une pompe de charges n'est pas impérative, l'homme de l'art connaissant diverses manières de réaliser des circuits survolteurs.

**Revendications**

1. Mémoire (10) programmable et effaçable électriquement, comprenant des moyens (30) de production, à partir d'une tension d'alimentation (Vcc), d'une haute tension (Vpp) de programmation ou d'effacement, caractérisée en ce qu'elle comprend :

   - une capacité électrique (Chv, $CR_2$) apte à maintenir la haute tension (Vpp) en cas de coupure de la tension d'alimentation (Vcc),
   - des moyens interrupteurs à mémoire ($SW_i$) alimentés par la haute tension (Vpp), agencés pour maintenir, en cas de coupure de la tension d'alimentation (Vcc), l'acheminement de la haute tension (Vpp) vers des cellules ($C_{i,j}$) de la mémoire en cours de programmation ou d'effacement.

2. Mémoire selon la revendication 1, comprenant :

   - des moyens interrupteurs à mémoire ($SW_i$) dont les sorties (OUT) commandent des transistors ($TPGR_1$, $TPGR_2$) d'acheminement de la haute tension (Vpp),
   - des moyens interrupteurs à mémoire ($SW_i$) dont les sorties (OUT) commandent des transistors ($TSWL_i$, $TSBL_i$) de sélection des cellules de la mémoire, et
   - des moyens interrupteurs à mémoire ($SW_i$) dont les sorties (OUT) commandent des transistors ($TPGR_1$) de connexion à la masse.

3. Mémoire selon la revendication 2, dans laquelle lesdits moyens interrupteurs à mémoire ($SW_i$) comprennent au moins deux portes inverseuses (INV1, INV2) en boucle fermée alimentées par la haute tension (Vpp) et commandées par l'intermédiaire de transistors d'isolement ($TI_i$).

4. Mémoire selon l'une des revendications précédentes, dans laquelle ladite capacité apte à maintenir la haute tension (Vpp) comprend une capacité de stabilisation (Chv) présente dans lesdits moyens (30) de production de la haute tension.

5. Mémoire selon l'une des revendications 1 à 4, dans laquelle ladite haute tension (Vpp) est appliquée par l'intermédiaire d'un circuit (34) générateur de rampe (Vpp), comprenant des moyens ($TR_4$, 40, 40', 50, 60) pour inhiber ledit circuit (34) générateur de rampe en cas de coupure de la tension d'alimentation (Vcc).

6. Mémoire selon la revendication 5, dans laquelle lesdits moyens ($TR_4$, 40, 50, 60) pour inhiber le circuit (34) générateur de rampe comprennent :

   - un circuit (40, 40') de détection des coupures de la tension d'alimentation (Vcc), se déclenchant lorsqu'une coupure de la tension d'alimentation est détectée,
   - un circuit (50) de surveillance de la tension (Vpp) à la sortie du circuit (34) générateur de rampe se déclenchant (DETECT) lorsque la tension de rampe (Vpp) atteint un seuil d'efficacité (Vppmin),

   le circuit (34) générateur de rampe étant inhibé lorsque les deux circuits sont déclenchés.

7. Mémoire selon la revendication 6, dans laquelle le circuit (40) de détection des coupures de la tension d'alimentation (Vcc) est agencé pour surveiller la tension d'alimentation et se déclencher lorsque la tension d'alimentation est inférieure à un seuil déterminé (Vccmin).

8. Mémoire selon la revendication 6, dans laquelle le circuit (40') de détection des coupures de la tension d'alimentation est agencé pour surveiller une haute tension (Vppreg) appliquée au circuit (34) générateur de rampe et se déclencher lorsque la haute tension ((Vppreg) est inférieure à sa valeur normale (Vregnom).

9. Microcircuit (1) comprenant une mémoire (10) selon l'une des revendications 1 à 8 et un circuit logique (20) utilisant la mémoire (10) comme moyen de stockage de données.

10. Microcircuit selon la revendication 9 dans lequel, à l'apparition de la tension d'alimentation (Vcc), la mise en marche du circuit logique (20) est retardée d'un intervalle de temps de l'ordre de la durée d'une opération de programmation ou d'effacement de la mémoire (10).

11. Microcircuit selon la revendication 10, dans lequel la mise en marche du circuit logique (20) est retardée à la condition que la haute tension (Vpp) soit présente à la sortie des moyens (30) de production de la haute tension (Vpp).

12. Procédé pour pallier les risques d'inscription de données erronées dans une mémoire (10) programmable et effaçable électriquement lorsqu'une coupure d'une tension d'alimentation (Vcc) de ladite mémoire (10) intervient au cours d'une opération de programmation ou d'effacement de cellules ($C_{i,j}$) de la mémoire, la mémoire (10) comprenant des moyens (30) de production d'une haute tension (Vpp) de programmation ou d'effacement, caractérisé en ce qu'il comprend les opérations consistant à :

- prévoir une capacité électrique (Chv, $CR_2$) apte à maintenir la haute tension (Vpp), en cas de coupure de la tension d'alimentation (Vcc), pendant le temps nécessaire à l'opération de programmation ou d'effacement,
- prévoir des moyens interrupteurs à mémoire ($SW_i$) alimentés par la haute tension (Vpp), pour maintenir, en cas de coupure de la tension d'alimentation (Vcc), l'acheminement de la haute tension (Vpp) vers des cellules ($C_{i,j}$) de la mémoire en cours de programmation ou d'effacement.

13. Procédé selon la revendication 12, dans lequel ladite capacité comprend au moins une capacité de stabilisation (Chv, $CR_2$) présente dans les moyens (30) de production de la haute tension (Vpp).

14. Procédé selon l'une des revendications 12 et 13 dans lequel on prévoit :

- des moyens interrupteurs à mémoire ($SW_i$) dont les sorties (OUT) commandent des transistors ($TPGR_1$, $TPGR_2$) d'acheminement de la haute tension (Vpp),
- des moyens interrupteurs à mémoire ($SW_i$) dont les sorties (OUT) commandent des transistors ($TSWL_i$, $TSBL_i$) de sélection des cellules de la mémoire, et
- des moyens interrupteurs à mémoire ($SW_i$) dont les sorties (OUT) commandent des transistors ($TPGR_1$) de connexion à la masse.

15. Procédé selon l'une des revendications 12 à 14, comprenant en outre l'opération consistant à mettre hors tension ou inhiber des circuits (34) de la mémoire susceptibles de consommer du courant.

16. Procédé selon l'une des revendications 12 à 15, dans lequel on maintient l'acheminement de la haute tension (Vpp) à la condition que la haute tension (Vpp) appliquée à la mémoire (10) présente une valeur supérieure ou égale à un seuil d'efficacité (Vppmin) au moment où la coupure de la tension d'alimentation (Vcc) intervient.

17. Procédé selon l'une des revendications 12 à 16, dans lequel une détection des coupures de la tension d'alimentation (Vcc) consiste à déterminer si la tension d'alimentation est inférieure à un seuil prédéterminé (Vccmin).

18. Procédé selon l'une des revendications 12 à 16, dans lequel une détection des coupures de la tension d'alimentation (Vcc) consiste à déterminer si une tension (Vppreg) présente dans les moyens (30) de production de la haute tension (Vpp) est inférieure à sa valeur normale (Vregnom).

**Patentansprüche**

1. Elektrisch programmierbarer und löschbarer Speicher (10), welcher Mittel (30) umfaßt, um ausgehend von einer Versorgungsspannung (Vcc) eine Hochspannung (Vpp) für die Programmierung oder Löschung zu schaffen, dadurch gekennzeichnet, daß er umfaßt:

- eine elektrische Kapazität (Chv, $CR_2$), welche geeignet ist, die Hochspannung (Vpp) im Falle der Unterbrechung der Versorgungsspannung (Vcc) zu halten,

- Speicherunterbrechungsmittel ($SW_i$), welche von der Hochspannung (Vpp) versorgt werden und eingerichtet sind, im Falle der Unterbrechung der Versorgungsspannung (Vcc), die Zuführung der Hochspannung (Vpp) zu Zellen ($C_{i,j}$), welche im Begriff programmiert oder gelöscht zu werden, aufrecht zu erhalten.

2. Speicher nach Anspruch 1, umfassend:

- Speicherunterbrechungsmittel ($SW_i$), deren Ausgänge (OUT) Transistoren ($TPGR_1$, $TPGR_2$) zur Zuführung der Hochspannung (Vpp) ansteuern,

- Speicherunterbrechungsmittel ($SW_i$), deren Ausgänge (OUT) Transistoren ($TSWL_i$, $TSBL_i$) zur Auswahl der Speicherzellen ansteuern, und

- Speicherunterbrechungsmittel ($SW_i$), deren Ausgänge (OUT) Transistoren ($TPGR_1$) zur Verbindung mit der Erde ansteuern.

3. Speicher nach Anspruch 2, bei welchem die Speicherunterbrechungsmittel ($SW_i$) mindestens zwei invertierende Anschlüsse (INV1, INV2) in geschlossener Schleife umfassen, welche von der Hochspannung (Vpp) versorgt werden und durch Zwischenschaltung von Isoliertransistoren ($TI_i$) angesteuert werden.

4. Speicher nach einem der vorangegangenen Ansprüche, bei welchem die Kapazität, welche geeignet ist die Hochspannung (Vpp) zu halten, eine Stabilisationskapazität (Chv) umfaßt, die in den Mitteln (30) zur Erzeugung der Hochspannung gegeben ist.

5. Speicher nach einem der Ansprüche 1 bis 4, bei welchem die Hochspannung (Vpp) durch Zwischenschaltung einer Rampenerzeugungs-Schaltung (34) angelegt wird, welche Mittel ($TR_4$, 40, 40', 50, 60) umfaßt, um die Rampenerzeugungs-Schaltung (34) im Fall der Unterbrechung der Versorgungsspannung (Vcc) zu hemmen.

6. Speicher nach Anspruch 5, bei welchem die Mittel ($TR_4$, 40, 40', 50, 60) zur Hemmung der Rampenerzeugungs-Schaltung (34) umfassen:

- eine Schaltung (40, 40') zur Erfassung von Unterbrechungen der Versorgungsspannung (Vcc), welche ausgelöst wird wenn die Unterbrechung der Versorgungsspannung erfaßt wird,

- eine Schaltung (50) zur Überwachung der Spannung (Vpp) am Ausgang der Rampenerzeugungs-Schaltung (34), welche ausgelöst wird (DETECT) wenn die Rampenspannung (Vpp) eine Effizienzschwelle (Vppmin) erreicht,

wobei die Rampenerzeugungs-Schaltung (34) gehemmt wird, wenn beide Schaltungen ausgelöst sind.

7. Speicher nach Anspruch 6, bei welchem die Schaltung (40) zur Erfassung der Unterbrechungen der Versorgungsspannung (Vcc) eingerichtet ist, um die Versorgungsspannung zu überwachen und auszulösen, wenn die Versorgungsspannung kleiner als eine bestimmte Schwelle (Vccmin) ist.

8. Speicher nach Anspruch 6, bei welchem die Schaltung (40') zur Erfassung von Unterbrechungen der Versorgungsspannung eingerichtet ist, um eine Hochspannung (Vppreg) zu überwachen, die angelegt wird an die Rampenerzeugungs-Schaltung (34), und auszulösen, wenn die Hochspannung (Vppreg) kleiner als ihr Normalwert (Vregnom) ist.

9. Mikroschaltung (1) umfassend einen Speicher (10) nach einem der Ansprüche 1 bis 8, und eine Logikschaltung (20), welche den Speicher (10) als Datenspeichermittel verwendet.

10. Mikroschaltung nach Anspruch 9, bei welcher beim Erscheinen der Versorgungsspannung (Vcc) das Einschalten der Logikschaltung (20) um ein Zeitintervall in der Größenordnung der Dauer eines Programmiervorgangs oder Löschungsvorgangs des Speichers (10) verzögert ist.

**11.** Mikroschaltung nach Anspruch 10, bei welcher das Einschalten der Logikschaltung (20) verzögert wird unter der Bedingung, daß die Hochspannung (Vpp) am Ausgang der Mittel (30) zur Erzeugung der Hochspannung (Vpp) vorliegt.

**12.** Verfahren zur Unterdrückung der Risiken des Einschreibens von fehlerhaften Daten in einen elektrisch programmierbaren und löschbaren Speicher (10), wenn eine Unterbrechung einer Versorgungsspannung (Vcc) des Speichers (10) im Verlauf eines Vorgangs der Programmierung und Löschung von Zellen ($C_{i,j}$) des Speichers auftritt, wobei der Speicher (10) Mittel (30) umfaßt zur Erzeugung einer Hochspannung (Vpp) für die Programmierung und Löschung, dadurch gekennzeichnet, daß es Vorgänge umfaßt, die darin bestehen:

- eine elektrische Kapazität (Chv, $CR_2$) vorzusehen, welche geeignet ist im Fall der Unterbrechung der Versorgungsspannung (Vcc), während der Zeit, die notwendig ist für den Programmierungsvorgang oder Löschungsvorgang, die Hochspannung (Vpp) aufrecht zu erhalten,

- Speicherunterbrechungsmittel ($SW_i$) vorzusehen, welche von der Hochspannung (Vpp) versorgt werden, um im Falle der Unterbrechung der Versorgungsspannung (Vcc) die Zuführung der Hochspannung (Vpp) zu Zellen ($C_{i,j}$) des Speichers, welche im Begriff programmiert oder gelöscht zu werden, aufrecht zu erhalten.

**13.** Verfahren nach Anspruch 12, bei welchem die Kapazität mindestens eine Stabilisationskapazität (Chv, $CR_2$) umfaßt, welche in den Mitteln (30) zur Erzeugung der Hochspannung (Vpp) vorliegt.

**14.** Verfahren nach einem der Ansprüche 12 oder 13, bei welchem vorgesehen sind:

- Speicherunterbrechungsmittel ($SW_i$), deren Ausgänge (OUT) Transistoren ($TPGR_1$, $TPGR_2$) zur Zuführung der Hochspannung (Vpp) ansteuern,

- Speicherunterbrechungsmittel ($SW_i$), deren Ausgänge (OUT) Transistoren ($TSWL_i$, $TSBL_i$) zur Auswahl von Speicherzellen ansteuern, und

- Speicherunterbrechungsmittel ($SW_i$), deren Ausgänge (OUT) Transistoren ($TPGR_1$) zur Verbindung mit der Erde ansteuern.

**15.** Verfahren nach einem der Ansprüche 12 bis 14, umfassend den Vorgang, der darin besteht, Schaltungen (34) des Speichers, welche im Stande sind Strom zu verbrauchen, von der Spannung zu trennen oder zu hemmen.

**16.** Verfahren nach einem der Ansprüche 12 bis 15, bei welchem die Zuführung der Hochspannung (Vpp) aufrecht erhalten wird unter der Bedingung, daß die Hochspannung (Vpp), welche am Speicher (10) in dem Moment anliegt als die Unterbrechung der Versorgungsspannung (Vcc) auftritt, einen Wert hat, der größer oder gleich einer Effizienzschwelle (Vppmin) ist.

**17.** Verfahren nach einem der Ansprüche 12 bis 16, bei welchem eine Erfassung von Unterbrechungen der Versorgungsspannung (Vcc) darin besteht zu bestimmen, ob die Versorgungsspannung kleiner ist als eine vorbestimmte Schwelle (Vccmin).

**18.** Verfahren nach einem der Ansprüche 12 bis 16, bei welchem eine Erfassung von Unterbrechungen der Versorgungsspannung (Vcc) darin besteht zu bestimmen, ob eine Spannung (Vppreg), die in den Mitteln (30) zur Erzeugung der Hochspannung (Vpp) auftritt, kleiner ist als ihr Normalwert (Vregnom).

**Claims**

**1.** Programmable and electrically erasable memory (10) having means (30) for producing a high voltage (Vpp) for programming or erasing, derived from a supply voltage (Vcc), characterised in that it comprises:

- an electrical capacitor (Chv, $CR_2$) designed to maintain the high voltage (Vpp) in the event of failure of the supply voltage (Vcc).

- memory interrupting means ($Sw_i$) fed by the high voltage (Vpp), and arranged to maintain, in the event of failure of the supply voltage (Vcc), the feeding of the high voltage (Vpp) to cells ($C_{i,j}$) of the memory in the course of programming or erasing.

2. Memory according to claim 1, comprising:

- memory interrupting means ($SW_i$) of which the outputs (OUT) control transistors ($TPGR_1$, $TPGR_2$) for directing the high voltage (Vpp),

- memory interrupting means ($SW_i$) of which the outputs (OUT) control transistors ($TSWL_i$, $TSBL_i$) for selecting cells of the memory, and

- memory interrupting means ($SW_i$) of which the outputs (OUT) control transistors ($TPGR_1$) for connection to earth.

3. Memory according to claim 2, in which the said memory interrupting means ($SW_i$) comprise at least two inverting ports (INV1, INV2) in a closed loop fed by the high voltage (Vpp) and controlled through the intermediary of isolating transistors ($TI_i$).

4. Memory according to one of the foregoing claims in which the said capacitor designed to maintain the high voltage (Vpp) comprises a stabilising capacitor (Chv) present in the said means (30) for producing the high voltage.

5. Memory according to one of claims 1 to 4, in which the said high voltage (Vpp) is applied through the intermediary of a ramp generating circuit (Vpp) (34), comprising means ($TR_4$, 40, 40', 50, 60) for inhibiting the said ramp generating circuit (34) in the event of failure of the supply voltage (Vcc).

6. Memory according to claim 5, in which the said means ($TR_4$, 40, 50, 60) for inhibiting the ramp generating circuit (34) comprise:

- a circuit (40, 40') for detecting failures of the supply voltage (Vcc), disconnecting when a failure of the supply voltage is detected,

- a circuit (50) for monitoring the voltage (Vpp) at the output of the ramp generating circuit (34) disconnecting (DETECT) when the ramp voltage (Vpp) reached an operative threshold (Vppmin),

the ramp generating circuit (34) being inhibited when the two circuits are disconnected.

7. Memory according to claim 6, in which the circuit (40) for detecting failures of the supply voltage (Vcc) is arranged to monitor the supply voltage and to disconnect when the supply voltage is below a predetermined threshold (Vccmin).

8. Memory according to claim 6, in which the circuit (40') for detecting failures of the supply voltage is designed to monitor a high voltage (Vppreg) applied to the ramp generating circuit (34) and to disconnect when the high voltage (Vppreg) is less than its normal value (Vregnom).

9. Microcircuit (1) comprising a memory (10) according to one of claims 1 to 8 and a logic circuit (20) using the memory (10) as means for storing data.

10. Microcircuit according to claim 9 in which, on the appearance of the supply voltage (Vcc), the putting into operation of the logic circuit (20) is delayed by an interval of time of the order of the duration of an operation for programming or erasing the memory (10).

11. Microcircuit according to claim 10, in which the putting into operation of the logic circuit (20) is delayed on the condition that the high voltage (Vpp) is present at the output of the means (30) for producing the high voltage (Vpp).

12. Process for mitigating the risks of writing in incorrect data into an electrically programmable and erasable memory (10) when a failure of a supply voltage (Vcc) to the said memory (10) intervenes in the course of an operation for programming or erasing cells ($C_{i,j}$) of the memory, the memory (10) having means (30) for producing a high voltage (Vpp) for programming or erasing, characterised in that it comprises the operations consisting of:

- providing an electrical capacitor (Chv, $CR_2$) designed to maintain the high voltage (Vpp), in the event of failure of the supply voltage (Vcc), during the period necessary for the programming or erasing operation,

- providing memory interrupting means ($SW_i$) fed from the high tension (Vpp) for maintaining, in the event of failure of the supply voltage (Vcc), the guiding of the high voltage (Vpp) to the cells ($C_{i,j}$) of the memory in the course of the programming or erasing.

13. Process according to claim 12, in which the said capacitor comprises at least one stabilising capacitor (Chv, $CR_2$) present in the means (30) for producing the high voltage (Vpp).

14. Process according to one of claims 12 and 13 in which there are provided:

- memory interrupting means ($SW_i$) of which the outputs (OUT) control transistors ($TPGR_1$, $TPGR_2$) for guiding the high voltage (Vpp),

- memory interrupting means ($SW_i$) of which the outputs (OUT) control transistors ($TSWL_i$), $TSBL_i$) for selecting cells of the memory and,

- memory interrupting means ($SW_i$) of which the output (OUT) control transistors ($TPGR_1$) for connection to earth.

15. Process according to one of claims 12 to 14, comprising furthermore the operation consisting in putting out of voltage or inhibiting current-consuming circuits (34) of the memory.

16. Process according to one of claims 12 to 15, in which the guiding of the high voltage (Vpp) is maintained on condition that the high voltage (Vpp) applied to the memory (10) has a value which is greater than or equal to an operative threshold (Vppmin) at the moment when the failure of the supply voltage (Vcc) takes place.

17. Process according to one of claims 12 to 16, in which detection of failures of the supply voltage (Vcc) consists in determining whether the supply voltage is below a predetermined threshold (Vccmin).

18. Process according to one of claims 12 to 16, in which detection of failures of the supply voltage (Vcc) consists in determining whether a voltage (Vppreg) present in the means (30) for producing the high voltage (Vpp) is less than its normal value (Vregnom).

**FIG.1**

**FIG.2**

**FIG.4**

FIG.3

EP 0 902 949 B1

**FIG.5**

**FIG.6**

**FIG.7**

FIG.8

FIG.9

FIG.10